(19) Europäisches Patentamt / European Patent Office / Office européen des brevets

(11) **EP 3 961 694 B1**

(12) **EUROPEAN PATENT SPECIFICATION**

(45) Date of publication and mention
of the grant of the patent:
**09.08.2023 Bulletin 2023/32**

(51) International Patent Classification (IPC):
*H01L 23/373* (2006.01)   *H01L 23/15* (2006.01)
*H01L 23/28* (2006.01)   *H01L 25/07* (2006.01)
*H01L 25/18* (2023.01)   *H05K 1/02* (2006.01)
*H05K 1/03* (2006.01)   *H01L 23/495* (2006.01)
*H01L 23/498* (2006.01)   *H01L 23/36* (2006.01)
*H01L 23/31* (2006.01)   *H05K 3/00* (2006.01)
*H05K 3/28* (2006.01)

(21) Application number: **20794557.7**

(22) Date of filing: **27.03.2020**

(52) Cooperative Patent Classification (CPC):
(C-Sets available)
**H01L 23/3735; H01L 23/15; H01L 23/49531;
H01L 23/49562; H01L 23/49844;** H01L 23/3107;
H01L 23/36; H01L 2224/32225; H01L 2924/181;
H01L 2924/19107; H05K 1/0306; H05K 3/0058;
H05K 3/284                                   (Cont.)

(86) International application number:
**PCT/JP2020/014026**

(87) International publication number:
**WO 2020/217851 (29.10.2020 Gazette 2020/44)**

(54) **ELECTRONIC COMPONENT MODULE AND SILICON NITRIDE CIRCUIT SUBSTRATE**

ELEKTRONISCHES KOMPONENTENMODUL UND SCHALTSUBSTRAT AUS SILIZIUMNITRID

MODULE DE COMPOSANT ÉLECTRONIQUE ET SUBSTRAT DE CIRCUIT DE NITRURE DE SILICIUM

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **26.04.2019 JP 2019085446**

(43) Date of publication of application:
**02.03.2022 Bulletin 2022/09**

(73) Proprietor: **Denka Company Limited**
**Tokyo 103-8338 (JP)**

(72) Inventors:
• **YAMAGATA, Toshitaka**
**Tokyo 103-8338 (JP)**
• **TERANO, Katsunori**
**Tokyo 103-8338 (JP)**

(74) Representative: **Gulde & Partner**
**Patent- und Rechtsanwaltskanzlei mbB**
**Wallstraße 58/59**
**10179 Berlin (DE)**

(56) References cited:
**WO-A1-2015/022994      JP-A- 2009 070 863**
**JP-A- 2017 174 875      JP-A- 2018 046 192**
**JP-A- 2019 033 129**

(52) Cooperative Patent Classification (CPC): (Cont.)

C-Sets
H01L 2924/181, H01L 2924/00012

C-Sets
H01L 2924/181, H01L 2924/00012

**Description**

TECHNICAL FIELD

The present invention relates to an electronic component module.

BACKGROUND ART

From the viewpoint of thermal conductivity, cost, safety, and the like, a circuit board using ceramic substrates of alumina, beryllia, silicon nitride, and aluminum nitride is used for a power module or the like. These ceramic substrates are used as the circuit board by being bonded to a metal circuit layer, such as copper or aluminum, or a heat dissipation layer. These ceramic substrates have excellent insulation property and heat dissipation property compared to a resin substrate or a metal substrate of which an insulating material is a resin layer, and thus the ceramic substrates are used as a substrate on which an electronic component having high heat dissipation property is mounted.

For power module applications such as elevators, vehicles, and hybrid cars, a ceramic circuit board is used in which a metal circuit board is bonded to a surface of a ceramic substrate with a brazing material and a semiconductor element is mounted at a predetermined position on the metal circuit board. In recent years, the ceramic substrate, such as an aluminum nitride sintered body or a silicon nitride sintered body, which has high thermal conductivity in response to an increase in an amount of heat generated from the semiconductor element due to high integration, high frequency, and high output of the semiconductor element is used. Above all, in particular, high mechanical reliability is required for the ceramic substrate on which the electronic component is mounted, a silicon nitride substrate having excellent mechanical strength or toughness is attracting attention.

In addition, in an electronic component module and the like, since a thermal stress is repeatedly applied to the electronic component module, in a case in which the electronic component module cannot withstand the thermal stress, there is a problem that minute cracks are generated on the ceramic substrate or components, which constitute the electronic component module, are peeled off from each other, and thus poor bonding strength or poor thermal resistance is caused and the operational reliability and yield as an electronic device are lowered.

Therefore, for example, Patent Document 1 discloses a manufacturing method of a resin sealed power module in which a power module, which is constituted by a power module substrate having a circuit layer formed on one surface of a ceramic substrate made of silicon nitride and a semiconductor element mounted on the circuit layer of the power module substrate, is sealed with a mold resin. In addition, Patent Document 1 discloses that by the manufacturing method including a step of adjusting surface roughness of a contact surface of the ceramic substrate with the mold resin to a specific range, bonding reliability between the semiconductor element and the power module substrate can be improved.

RELATED DOCUMENT

PATENT DOCUMENT

[Patent Document 1] Japanese Unexamined Patent Publication No. 2018-46192

However, in the electronic component module and the like, high output and high integration progress, and the thermal stress repeatedly applied to the electronic component module tends to increase. Therefore, in the related art, there is a case in which the ceramic substrate cannot withstand the thermal stress, for example, the components, which constitute the electronic component module, are peeled off from each other or minute cracks are generated, so that poor bonding strength or poor thermal resistance is caused, and thus the reliability of the electronic component module in which the electronic component, such as the semiconductor element, is mounted on the ceramic circuit board is not sufficient.

SUMMARY OF THE INVENTION

PROBLEM TO BE SOLVED

In view of the problems described above, an object of the present invention is to obtain an electronic component module having high reliability and yield and a silicon nitride circuit board which can be used as the electronic component module having high reliability and yield.

SOLUTION TO PROBLEM

According to the present invention, an electronic component module as defined in claim 1 is provided.

That is, the present invention provides an electronic component module including a silicon nitride circuit board, an electronic component mounted over the silicon nitride circuit board, and a sealing resin portion that seals all or a part of the silicon nitride circuit board and the electronic component, in which the silicon nitride circuit board includes a silicon nitride substrate, a first copper layer provided over one surface of the silicon nitride substrate, and a second copper layer provided over the other surface of the silicon nitride substrate, a surface of the second copper layer opposite to a surface over which the silicon nitride substrate is provided is bonded to a heat sink directly or through a bonding material layer, and in a case in which a coefficient of linear expansion of the heat sink is defined as $\alpha_H$ (/°C) , a Young's modulus of the heat sink is defined as $E_H$ (GPa), a coefficient of linear expansion of the sealing resin portion is defined as $\alpha_R$ (/°C), and a Young's modulus of the sealing resin portion is defined as $E_R$ (GPa), S1 calculated by the following equation (1) is equal to or more than -0.38 (GPa) and equal to or less than -0.23 (GPa), and S2 calculated by the following equation (2) is equal to or more than -0.028 (GPa) and equal to or less than 0.019 (GPa),

$$\text{Equation (1): } S1 = (\alpha_{BC} - \alpha_H) \times E_H \times (290 - 25),$$

in which $\alpha_{BC}$ is an approximate value of a coefficient of linear expansion of a composite laminate of the silicon nitride substrate and the second copper layer, and in a case in which a coefficient of linear expansion of the silicon nitride substrate is defined as $\alpha_B$ (/°C), a Young's modulus of the silicon nitride substrate is defined as $E_B$ (GPa), a thickness of the silicon nitride substrate is defined as $T_B$ (mm), a coefficient of linear expansion of the second copper layer is defined as $\alpha_C$ (/°C), a Young's modulus of the second copper layer is defined as $E_C$ (GPa), and a thickness of the second copper layer is defined as $T_C$ (mm), $\alpha_{BC}$ is calculated by the following equation (3),

$$\text{Equation (3): } \alpha_{BC} = ((\alpha_B \times E_B \times T_B) + (\alpha_C \times E_C \times T_C))/((E_B \times T_B) + (E_C \times T_C)),$$

and

$$\text{Equation (2): } S2 = (\alpha_{ABC} - \alpha_R) \times E_R \times (290 - 25),$$

in which $\alpha_{ABC}$ is an approximate value of a coefficient of linear expansion of a composite laminate of the first copper layer, the silicon nitride substrate, and the second copper layer, and in a case in which a coefficient of linear expansion of the first copper layer is defined as $\alpha_A$ (/°C), a Young's modulus of the first copper layer is defined as $E_A$ (GPa), a thickness of the first copper layer is defined as $T_A$ (mm), the coefficient of linear expansion of the silicon nitride substrate is defined as $\alpha_B$ (/°C), the Young's modulus of the silicon nitride substrate is defined as $E_B$ (GPa), the thickness of the silicon nitride substrate is defined as $T_B$ (mm), the coefficient of linear expansion of the second copper layer is defined as $\alpha_C$ (/°C), the Young's modulus of the second copper layer is defined as $E_C$ (GPa), and the thickness of the second copper layer is defined as $T_C$ (mm), $\alpha_{ABC}$ is calculated by the following equation (4),

$$\text{Equation (4): } \alpha_{ABC} = ((\alpha_A \times E_A \times T_A) + ((\alpha_B \times E_B \times T_B) + (\alpha_C \times E_C \times T_C))/((E_A \times T_A) + (E_B \times T_B) + (E_C \times T_C)).$$

In addition, the present description discloses a silicon nitride circuit board including a silicon nitride substrate, a first copper layer provided over one surface of the silicon nitride substrate, and a second copper layer provided over the other surface of the silicon nitride substrate, in which all or a part of the silicon nitride circuit board is sealed with a sealing resin portion, the silicon nitride circuit board is used as a form in which a surface of the second copper layer opposite to a surface over which the silicon nitride substrate is provided is bonded to a heat sink directly or through a bonding material layer, and in a case in which a coefficient of linear expansion of the heat sink is defined as $\alpha_H$ (/°C), a Young's modulus of the heat sink is defined as $E_H$ (GPa), a coefficient of linear expansion of the sealing resin portion is defined as $\alpha_R$ (/°C), and a Young's modulus of the sealing resin portion is defined as $E_R$ (GPa), S1 calculated by the following equation (1) is equal to or more than -0.38 (GPa) and equal to or less than -0.23 (GPa), and S2 calculated by the following equation (2) is equal to or more than -0.028 (GPa) and equal to or less than 0.019 (GPa),

$$\text{Equation (1): } S1 = (\alpha_{BC} - \alpha_H) \times E_H \times (290 - 25),$$

in which $\alpha_{BC}$ is an approximate value of a coefficient of linear expansion of a composite laminate of the silicon nitride substrate and the second copper layer, and in a case in which a coefficient of linear expansion of the silicon nitride substrate is defined as $\alpha_B$ (/°C), a Young's modulus of the silicon nitride substrate is defined as $E_B$ (GPa), a thickness of the silicon nitride substrate is defined as $T_B$ (mm), a coefficient of linear expansion of the second copper layer is defined as $\alpha_C$ (/°C), a Young's modulus of the second copper layer is defined as $E_C$ (GPa), and a thickness of the second copper layer is defined as $T_C$ (mm), $\alpha_{BC}$ is calculated by the following equation (3),

$$\text{Equation (3): } \alpha_{BC} = ((\alpha_B \times E_B \times T_B) + (\alpha_C \times E_C \times T_C))/((E_B \times T_B) + (E_C \times T_C)),$$

and

$$\text{Equation (2): } S2 = (\alpha_{ABC} - \alpha_R) \times E_R \times (290 - 25),$$

in which $\alpha_{ABC}$ is an approximate value of a coefficient of linear expansion of a composite laminate of the first copper layer, the silicon nitride substrate, and the second copper layer, and in a case in which a coefficient of linear expansion of the first copper layer is defined as $\alpha_A$ (/°C), a Young's modulus of the first copper layer is defined as $E_A$ (GPa), a thickness of the first copper layer is defined as $T_A$ (mm), the coefficient of linear expansion of the silicon nitride substrate is defined as $\alpha_B$ (/°C), the Young's modulus of the silicon nitride substrate is defined as $E_B$ (GPa), the thickness of the silicon nitride substrate is defined as $T_B$ (mm), the coefficient of linear expansion of the second copper layer is defined as $\alpha_C$ (/°C), the Young's modulus of the second copper layer is defined as $E_C$ (GPa), and the thickness of the second copper layer is defined as $T_C$ (mm), $\alpha_{ABC}$ is calculated by the following equation (4),

$$\text{Equation (4): } \alpha_{ABC} = ((\alpha_A \times E_A \times T_A) + ((\alpha_B \times E_B \times T_B) + (\alpha_C \times E_C \times T_C))/((E_A \times T_A) + (E_B \times T_B) + (E_C \times T_C)).$$

## ADVANTAGEOUS EFFECTS OF INVENTION

The electronic component module according to the present invention is configured as described above and therefore can be used as the electronic component module having high reliability and yield.

## BRIEF DESCRIPTION OF THE DRAWINGS

Fig. 1 is a plan view of a silicon nitride circuit board according to the present embodiment.
Fig. 2 is a cross-sectional view of the silicon nitride circuit board according to the present embodiment.
Fig. 3 is a cross-sectional view of an electronic component module according to the present embodiment.
Fig. 4 is an enlarged cross-sectional view of a part of the electronic component module according to the present embodiment.

## DESCRIPTION OF EMBODIMENTS

Hereinafter, an embodiment of the present invention will be described below with reference to the drawings. Note that in all drawings, similar components are designated by the same reference numerals, and description thereof will not be repeated. In addition, the drawings are schematic views and do not match the actual dimensional ratio.
Hereinafter, a configuration of an electronic component module 200 according to the present embodiment will be described.

<Configuration of Electronic Component Module according to Present Embodiment>

The electronic component module 200 according to the present embodiment includes a silicon nitride circuit board 100, an electronic component 40 mounted on the silicon nitride circuit board 100, and a sealing resin portion 50 that seals all or a part of the silicon nitride circuit board 100 and the electronic component 40.

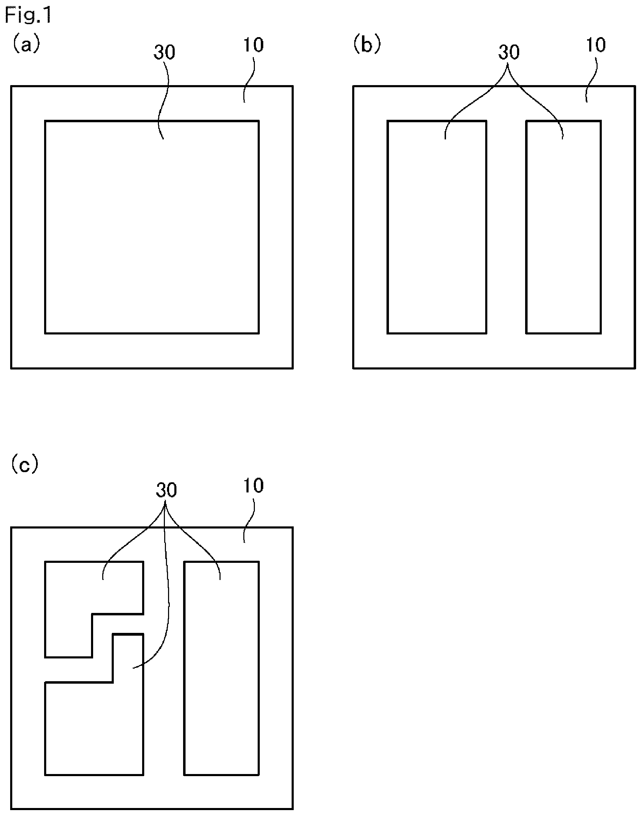

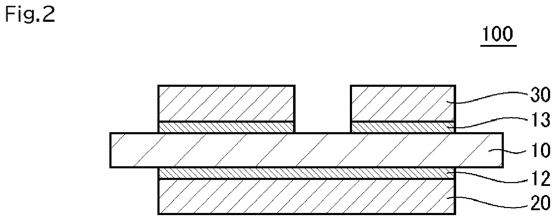

First, the silicon nitride circuit board 100 according to the present embodiment will be described with reference to Figs. 1 to 2. Fig. 1 is a plan view of the silicon nitride circuit board according to the present embodiment, and Fig. 2 is a cross-sectional view of the silicon nitride circuit board according to the present embodiment.

As shown in Fig. 2, the silicon nitride circuit board 100 according to the present embodiment includes a silicon nitride substrate 10, a first copper layer 30, and a second copper layer 20. In addition, the silicon nitride substrate 10 and the second copper layer 20 can be configured in a laminated state with a brazing material layer 12 interposed therebetween, and the silicon nitride substrate 10 and the first copper layer 30 can be configured in a laminated state with a brazing material layer 13 interposed therebetween.

In the present embodiment, a "silicon nitride-copper composite" is a state in which the silicon nitride substrate 10, the first copper layer 30, the brazing material layer 13, the silicon nitride substrate 10, the brazing material layer 12, and the second copper layer 20 are laminated, and refers to a state before a circuit pattern is formed. In addition, the "silicon nitride circuit board" refers to a state in which the circuit pattern is formed on a "silicon nitride-copper composite", and may be a state in which an electronic component, such as the electronic component 40, is mounted on a part of the copper layer on which the circuit pattern is formed.

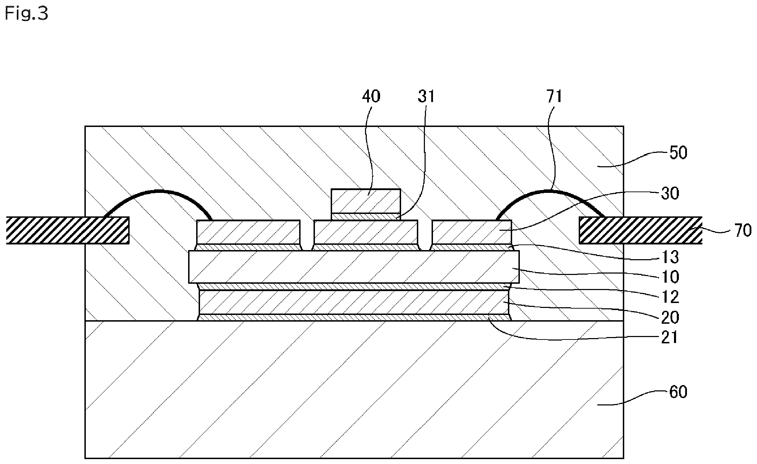

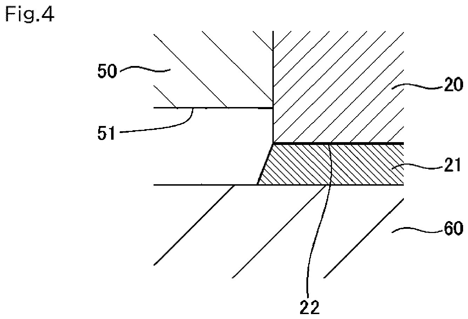

Subsequently, the electronic component module according to the present embodiment will be further described with reference to Figs. 3 to 4. Fig. 3 is a cross-sectional view of the electronic component module according to the present embodiment. In addition, Fig. 4 is an enlarged cross-sectional view of a part of the electronic component module according to the present embodiment.

As shown in Fig. 3, in the present embodiment, a surface of the second copper layer 20 opposite to a surface on which the silicon nitride substrate 10 is provided is bonded to a heat sink 60 directly or through the bonding material layer, and in an example of the present embodiment shown in Fig. 3, the second copper layer 20 is bonded to the heat sink 60 through a bonding material layer 21. In the present embodiment, all or a part of the silicon nitride circuit board 100 and the electronic component 40 are sealed with the sealing resin portion 50.

In the electronic component module according to the present embodiment, in a case in which a coefficient of linear expansion of the heat sink 60 is defined as $\alpha_H$ (/°C), a Young's modulus of the heat sink 60 is defined as $E_H$ (GPa), a coefficient of linear expansion of the sealing resin portion 50 is defined as $\alpha_R$ (/°C), and a Young's modulus of the sealing resin portion 50 is defined as $E_R$ (GPa), S1 calculated by the following equation (1) is equal to or more than -0.38 (GPa) and equal to or less than -0.23 (GPa), and S2 calculated by the following equation (2) is equal to or more than -0.028 (GPa) and equal to or less than 0.019 (GPa).

$$\text{Equation (1): } S1 = (\alpha_{BC} - \alpha_H) \times E_H \times (290 - 25)$$

$$\text{Equation (2): } S2 = (\alpha_{ABC} - \alpha_R) \times E_R \times (290 - 25)$$

Here, $\alpha_{BC}$ (/°C) is an approximate value of a coefficient of linear expansion of a composite laminate formed by the silicon nitride substrate and the second copper layer, and $\alpha_{ABC}$ (/°C) is an approximate value $\alpha_{ABC}$ (/°C) of a coefficient of linear expansion of a composite laminate formed by the first copper layer, the silicon nitride substrate, and the second copper layer.

According to the present invention, in the electronic component module having the configuration described above, S1 calculated by the above equation (1) and S2 calculated by the above equation (2) are set to a specific numerical range, so that the electronic component module having high reliability and yield can be obtained.

That is, the electronic component module and the silicon nitride circuit board constituting the electronic component module are manufactured by combining and bonding materials having different coefficients of linear expansion and the like, and there are many options of a material, a physical property, and a shape of each component, and combinations thereof. As a result of diligent studies, the present inventors have found that by defining a parameter related to a residual stress stored between a composite laminate formed by two layers of the silicon nitride substrate and the second copper layer which are adjacent to the heat sink and the heat sink, and a parameter related to a residual stress stored between a composite laminate (silicon nitride circuit board) formed by three layers of the first copper layer, the silicon nitride substrate, and the second copper layer and the sealing resin portion, the reliability and yield of the electronic component module can be improved, and have achieved the present invention.

S1 calculated in the above equation (1), that is, the residual stress stored between the composite laminate formed by the two layers of the silicon nitride substrate and the second copper layer and the heat sink is equal to or more than -0.38 GPa and equal to or less than -0.23 GPa, is preferably equal to or more than -0.36 GPa and equal to or less than -0.24 GPa, and more preferably equal to or more than -0.34 GPa and equal to or less than -0.25 GPa.

S2 calculated in the above equation (2), that is, the residual stress stored between the composite laminate formed by the three layers of the first copper layer, the silicon nitride substrate, and the second copper layer and the sealing resin portion is equal to or more than -0.028 GPa and equal to or less than 0.019 GPa, is preferably equal to or more than -0.020 GPa and equal to or less than 0.015 GPa, and more preferably equal to or more than -0.015 GPa and equal to or less than 0.010 GPa.

S1 represented by the equation (1) and S2 represented by the equation (2) can be adjusted by appropriately selecting the type, the physical property, the shape, and the like of the material of each component used in the electronic component module.

Here, in a case in which a coefficient of linear expansion of the silicon nitride substrate is defined as $\alpha_B$ (/°C), a Young's modulus of the silicon nitride substrate is defined as $E_B$ (GPa), a thickness of the silicon nitride substrate is defined as $T_B$ (mm), a coefficient of linear expansion of the second copper layer is defined as $\alpha_C$ (/°C), a Young's modulus of the second copper layer is defined as $E_C$ (GPa), and a thickness of the second copper layer is defined as $T_C$ (mm), an approximate value $\alpha_{BC}$ (/°C) of the coefficient of linear expansion of the composite laminate formed by the silicon nitride substrate and the second copper layer is calculated by the following equation (3) .

$$\text{Equation (3): } \alpha_{BC} = ((\alpha_B \times E_B \times T_B) + (\alpha_C \times E_C \times T_C))/((E_B \times T_B) + (E_C \times T_C))$$

$\alpha_{BC}$ (/°C) is preferably equal to or more than $1.0 \times 10^{-6}$ /°C and equal to or less than $3.0 \times 10^{-5}$ /°C, and more preferably equal to or more than $3.0 \times 10^{-6}$ /°C and equal to or less than $2.0 \times 10^{-5}$ /°C.

In addition, in a case in which a coefficient of linear expansion of the first copper layer is defined as $\alpha_A$ (/°C), a Young's modulus of the first copper layer is defined as $E_A$ (GPa), a thickness of the first copper layer is defined as $T_A$ (mm), the coefficient of linear expansion of the silicon nitride substrate is defined as $\alpha_B$ (/°C), the Young's modulus of the silicon nitride substrate is defined as $E_B$ (GPa), the thickness of the silicon nitride substrate is defined as $T_B$ (mm), the coefficient of linear expansion of the second copper layer is defined as $\alpha_C$ (/°C), the Young's modulus of the second copper layer is defined as $E_C$ (GPa), and the thickness of the second copper layer is defined as $T_C$ (mm), an approximate value $\alpha_{ABC}$ of the coefficient of linear expansion of the composite laminate formed by the three layers of the first copper layer, the silicon nitride substrate, and the second copper layer is calculated by the following equation (4) .

$$\text{Equation (4): } \alpha_{ABC} = ((\alpha_A \times E_A \times T_A) + ((\alpha_B \times E_B \times T_B) + (\alpha_C \times E_C \times T_C))/((E_A \times T_A) + (E_B \times T_B) + (E_C \times T_C))$$

$\alpha_{ABC}$ (/°C) is preferably equal to or more than $1.0 \times 10^{-6}$ /°C and equal to or less than $3.0 \times 10^{-5}$ /°C, and more preferably equal to or more than $5.0 \times 10^{-6}$ /°C and equal to or less than $2.0 \times 10^{-5}$ /°C.

When $\alpha_{BC}$ (/°C) and $\alpha_{ABC}$ (/°C) are in the numerical range described above, the reliability of the electronic component module can be further improved.

The silicon nitride circuit board 100 according to the present invention shows the silicon nitride circuit board 100 in the electronic component module 200 according to the present embodiment described above. That is, all or a part of the silicon nitride circuit board 100 according to the present invention is sealed with the sealing resin portion 50, the silicon nitride circuit board 100 is used as a form in which the surface of the second copper layer 20 opposite to the surface on which the silicon nitride substrate 10 is provided is bonded to the heat sink directly or through the bonding material layer 21.

In the present embodiment, the first copper layer 30 is a copper layer formed in a circuit pattern. The electronic component 40 is bonded to the first copper layer 30 through a solder layer 31, and the first copper layer 30 or the electronic component 40 is connected to an external connection terminal 70 by a lead frame for external connection or a wire bonding 71. In the present embodiment, as an example, an example is described in which the wire bonding 71 is connected to the external connection terminal 70. In addition, the external connection terminal 70 can be directly connected to the circuit board without using the wire bonding 71. In this case, the external connection terminal 70 can be bonded thereto by, for example, soldering or ultrasound bonding.

The electronic component 40 is an electronic component, such as a semiconductor element, and various semiconductor elements, such as an insulated gate bipolar transistor (IGBT), a metal oxide semiconductor field effect transistor (MOSFET), and a free wheeling diode (FWD), can be selected depending on a desired function.

The solder layer 31 that bonds the electronic component 40 can be made of, for example, a Sn-Sb-based, Sn-Ag-based, Sn-Cu-based, Sn-In-based, or Sn-Ag-Cu-based solder material (so-called lead-free solder material).

In addition, the external connection terminal 70 is made of, for example, copper or a copper alloy, and the wire bonding 71 is made of, for example, copper, a copper alloy, aluminum, gold, or the like.

In addition, in the present embodiment, the second copper layer 20 is a copper layer for bonding to a heat sink.

In the present embodiment, the second copper layer 20 is bonded to the heat sink 60 through the bonding material layer 21.

As described above, in the present embodiment, all or a part of the silicon nitride circuit board 100 and the electronic component 40 are sealed with the sealing resin portion 50.

Here, it is preferable that the surface of the second copper layer 20 opposite to the surface on which the silicon nitride substrate 10 is provided, that is, a lower surface 22 of the second copper layer has an uncovered region that is not covered with the sealing resin portion 50. Stated another way, it is preferable that all or a part of the lower surface 22 of the second copper layer be not covered with the sealing resin portion 50.

In addition, in the electronic component module according to the present embodiment, it is preferable that the surface of the second copper layer 20 opposite to the surface on which the silicon nitride substrate 10 is provided, that is, the lower surface 22 of the second copper layer protrude further than the sealing resin portion 50 in a direction away from the silicon nitride substrate 10. That is, as shown in Fig. 4, in a case in which the surface of the sealing resin portion 50 facing the heat sink 60 is defined as a lower surface 51 of the sealing resin portion, and the surface of the second copper layer 20 facing the heat sink 60 is defined as the lower surface 22 of the second copper layer, there is a step between the lower surface 51 of the sealing resin portion and the bonding material layer 21, and the lower surface 22 of the second copper layer is designed to protrude with respect to the lower surface 51 of the sealing resin portion. By designing in this way, in a step of bonding the silicon nitride circuit board 100 to the heat sink 60, that is, in a step of bonding the exposed lower surface 22 of the second copper layer 20 (uncovered region that is not covered with the sealing resin portion 50) to the heat sink 60, in a case in which the silicon nitride circuit board 100 and the heat sink 60 are pressed and brought contact with each other, the lower surface 22 of the second copper layer is firstly in contact with the heat sink 60, so that the lower surface 22 of the second copper layer can be bonded to the heat sink 60 smoothly without the sealing resin portion 50 interfering with the bonding, and the reliability of bonding the second copper layer 20 and the heat sink 60 can be improved.

Each configuration of the silicon nitride circuit board 100 according to the present embodiment will be described below in more detail.

<Silicon Nitride Substrate>

The silicon nitride substrate 10 according to the present embodiment has a function of supporting the first copper layer 30 and the second copper layer 20. Here, the silicon nitride substrate has a rectangular shape when seen in a thickness direction thereof. In addition, a thickness $T_B$ of the silicon nitride substrate 10 is preferably set in a range of equal to or more than 0.2 mm and equal to or less than 1.5 mm, more preferably set to equal to or more than 0.2 mm and equal to or less than 0.8 mm, and is set to 0.32 mm in the present embodiment. The shape and the like of the silicon nitride substrate 10 are examples in the present embodiment, and may be different from the present embodiment as long as the function according to the present invention is exhibited.

A Young's modulus $E_B$ of the silicon nitride substrate 10 according to the present embodiment is preferably equal to or more than 250 GPa and equal to or less than 320 GPa, and more preferably equal to or more than 260 GPa and equal to or less than 310 GPa.

In addition, the coefficient of linear expansion $\alpha_B$ of the silicon nitride substrate 10 according to the present embodiment is preferably equal to or more than $1.5 \times 10^{-6}$ /°C and equal to or less than $4.0 \times 10^{-6}$ /°C, and more preferably equal to or more than $1.8 \times 10^{-6}$ /°C and less than $3.0 \times 10^{-6}$ /°C.

By adjusting the physical properties of the silicon nitride substrate 10 in the aspect described above, S1 and S2 can be easily adjusted in the numerical range described above, also, the reliability and yield of the electronic component module can be further improved.

Note that the physical properties such as the Young's modulus $E_B$, and the coefficient of linear expansion $\alpha_B$ of the silicon nitride substrate 10 can be adjusted by controlling a manufacturing method of the silicon nitride substrate 10, specifically, the blending of the raw materials, the baking conditions, and the like.

<First Copper Layer>

The first copper layer 30 has a polygonal shape when seen in a thickness direction thereof. A thickness of the first copper layer 30 is preferably set in a range of equal to or more than 0.10 mm and equal to or less than 1.50 mm, more preferably equal to or more than 0.15 mm and equal to or less than 1.40 mm, and still more preferably equal to or more than 0.20 mm and equal to or less than 1.20 mm. In the present embodiment, the thickness thereof is set to 0.30 mm as an example. Note that the shape and the like of the first copper layer 30 is an example in the present embodiment, and may be different from the present embodiment as long as the function according to the present invention is exhibited.

The coefficient of linear expansion of the first copper layer 30 according to the present embodiment can be preferably equal to or more than $16 \times 10^{-6}$ /°C and equal to or less than $19 \times 10^{-6}$ /°C, and more preferably equal to or more than $17 \times 10^{-6}$ /°C and equal to or less than $18 \times 10^{-6}$ /°C.

The Young's modulus of the first copper layer 30 is preferably equal to or more than 90 GPa and equal to or less than 150 GPa, more preferably equal to or more than 100 GPa and equal to or less than 140 GPa, and still more preferably equal to or more than 110 GPa and equal to or less than 130 GPa.

By adjusting the physical properties of the first copper layer 30 and the second copper layer 20 in the aspect described above, S2 can be easily adjusted in the numerical range described above, and the reliability and yield of the electronic component module can be further improved.

An average crystal grain size of copper crystals in the first copper layer 30 is preferably equal to or more than 50 um and equal to or less than 500 um, and more preferably equal to or more than 100 um and equal to or less than 300 um.

In the electronic component module according to the present embodiment, since the electronic component 40 is mounted on the first copper layer 30 through a bonding layer, such as the solder layer 31, and is covered with the sealing resin portion 50, the first copper layer 30 is interposed between the sealing resin portion 50, the solder layer first copper layer 30, the electronic component 40, the silicon nitride substrate 10, and the like, and the residual stress or the thermal stress is applied between these materials. However, by setting the average crystal grain size of the copper crystals in the first copper layer 30 in the numerical range described above, poor bonding strength or poor thermal resistance can be further reduced. Although the mechanism described above is not clear, it is presumed that by setting the average crystal grain size of the copper crystals in the first copper layer 30 in the numerical range described above, grain boundary sliding appropriately occurs in the copper crystals in the first copper layer 30 and the stress is appropriately relaxed.

<Second Copper Layer>

The second copper layer 20 has a polygonal shape when seen in a thickness direction thereof. A thickness of the second copper layer 20 is preferably set in a range of equal to or more than 0.10 mm and equal to or less than 1.50 mm, more preferably equal to or more than 0.15 mm and equal to or less than 1.40 mm, and still more preferably equal to or more than 0.20 mm and equal to or less than 1.20 mm. In the present embodiment, the thickness thereof is set to 0.30 mm as an example. Note that the shape and the like of the second copper layer 20 is an example in the present embodiment, and may be different from the present embodiment as long as the function according to the present invention is exhibited.

The coefficient of linear expansion of the second copper layer 20 according to the present embodiment can be preferably equal to or more than $16 \times 10^{-6}$ /°C and equal to or less than $19 \times 10^{-6}$ /°C, and more preferably equal to or more than $17 \times 10^{-6}$ /°C and equal to or less than $18 \times 10^{-6}$ /°C.

By adjusting the physical properties of the second copper layer 20 in the aspect described above, S1 and S2 can be easily adjusted in the numerical range described above, and the reliability and yield of the electronic component module can be further improved.

An average crystal grain size of copper crystals in the second copper layer 20 is preferably equal to or more than 50 um and equal to or less than 500 um, and more preferably equal to or more than 100 um and equal to or less than 300 um.

In a case in which the silicon nitride circuit board 100 according to the present embodiment is used as the electronic component module as described below, a heat sink is bonded to the second copper layer 20 through the bonding material layer 21, such as the solder layer, the second copper layer 20 is interposed between the bonding material layer 21, such as the solder layer, and the heat sink 60, and the silicon nitride substrate 10, and the like, and the residual stress or the thermal stress is applied between these different materials. However, by setting the average crystal grain size of the copper crystals in the second copper layer 20 in the numerical range described above, poor bonding strength or poor thermal resistance can be further reduced. Although the mechanism described above is not clear, it is presumed that by setting the average crystal grain size of the copper crystals in the second copper layer 20 in the numerical range described above, grain boundary sliding appropriately occurs in the copper crystals in the second copper layer 20 and the stress is appropriately relaxed.

The Young's modulus of the second copper layer 20 is preferably equal to or more than 90 GPa and equal to or less than 150 GPa, more preferably equal to or more than 100 GPa and equal to or less than 140 GPa, and still more preferably equal to or more than 110 GPa and equal to or less than 130 GPa.

Note that the coefficients of linear expansion, the Young's moduli, and the average crystal grain sizes of the copper crystals in the first copper layer 30 and the second copper layer 20 can be adjusted by appropriately selecting the copper plates constituting the first copper layer 30 and the second copper layer 20 and controlling a manufacturing condition in a case in which the first copper layer 30 and the second copper layer 20 are brazed to the silicon nitride substrate 10.

In addition, the average crystal grain sizes of the copper crystals in the first copper layer 30 and the second copper layer 20 can be obtained by the method described in Examples.

<Brazing Material Layer>

The brazing material layer 12 and the brazing material layer 13 according to the present embodiment are disposed between the silicon nitride substrate 10 and the first copper layer 30, and between the silicon nitride substrate 10 and the second copper layer 20, respectively, and bond the first copper layer 30 or the second copper layer 20 to the silicon nitride substrate 10. Thicknesses of the brazing material layer 12 and the brazing material layer 13 are typically set in a range of equal to or more than 3 um and equal to or less than 40 um, and more preferably equal to or more than 4 um and equal to or less than 25 um.

Note that the silicon nitride circuit board 100 according to the present embodiment may include a plating layer on the first copper layer 30 and the second copper layer 20. The plating layer can be made of a known material, and can be, for example, Ag, Ni-P, and the like.

The composition of the brazing material layers 12 and 13 can be made of a silver-copper-based brazing material containing at least one type of active metal selected from titanium, zirconium, hafnium, niobium, tantalum, vanadium, aluminum, and tin in the brazing material. A blending ratio of Ag, Cu, and Sn or In is preferably a ratio of Ag of equal to or more than 85.0 parts by mass and equal to or less than 95.0 parts by mass, Cu of equal to or more than 5.0 parts by mass and equal to or less than 13.0 parts by mass, Sn or In of equal to or more than 0.4 parts by mass and equal to or less than 3.5 parts by mass. By setting the ratio in the numerical range described above, a melting temperature of the brazing material can be prevented from rising excessively, bonding at an appropriate temperature is possible, the thermal stress derived from a difference in the coefficients of thermal expansion at the time of bonding can be lowered, and thus a thermal resistance cycle property can be improved.

An addition amount of the active metal, such as titanium, can be, for example, equal to or more than 1.5 parts by mass and equal to or less than 5.0 parts by mass with respect to 100 parts by mass in total of Ag, Cu, and Sn or In. By appropriately adjusting the addition amount of the active metal, the wettability to a ceramic plate can be further improved, and the occurrence of bonding defects can be further suppressed.

<Sealing Resin Portion>

In the present embodiment, the coefficient of linear expansion of the sealing resin portion 50 can be preferably equal to or more than $5 \times 10^{-6}$ /°C and equal to or less than $30 \times 10^{-6}$ /°C, more preferably equal to or more than $6 \times 10^{-6}$ /°C and equal to or less than $20 \times 10^{-6}$ /°C, and still more preferably equal to or more than $6 \times 10^{-6}$ /°C and equal to or less than $15 \times 10^{-6}$ /°C. As the sealing resin portion 50, for example, an epoxy-based resin with a $SiO_2$ filler can be used.

The Young's modulus of the sealing resin portion 50 is preferably equal to or more than 50 GPa and equal to or less than 80 GPa, more preferably equal to or more than 10 GPa and equal to or less than 60 GPa, and still more preferably equal to or more than 15 GPa and equal to or less than 40 GPa.

The sealing resin portion 50 can be formed by hardening a resin composition for forming the sealing resin portion.

A type of the resin composition for forming the sealing resin portion is not particularly limited, and a resin composition usually used in the technical field, such as a resin composition for transfer mold, a resin composition for compression molding, and a liquid sealing material, can be used.

The resin composition for forming the sealing resin portion preferably contains a thermosetting resin, more preferably contains one type or two or more types of selected from an epoxy resin, a phenol resin, a cyanate resin, a bismaleimide triazine resin, an acrylic resin, and a silicon resin, and still more preferably contains at least an epoxy resin.

The resin composition for forming the sealing resin portion may further contain a hardening agent, a filler, and the like.

Examples of the filler include powder of molten silica (spherical silica), crystalline silica, alumina, silicon carbide, silicon nitride, aluminum nitride, boron nitride, beryllia, zirconia, or spherical beads thereof, a glass fiber, an aramid fiber, a carbon fiber, and the like. One type of the filler may be used alone or two or more types thereof may be used in combination.

<Heat Sink>

For example, the heat sink 60 is made of a material having a high thermal conductivity, such as aluminum, copper, or an alloy thereof, and is preferably made of aluminum or an aluminum alloy.

The coefficient of linear expansion of the heat sink is preferably equal to or more than $20 \times 10^{-6}$ /°C and equal to or less than $30 \times 10^{-6}$ /°C, and more preferably equal to or more than $22 \times 10^{-6}$ /°C and equal to or less than $28 \times 10^{-6}$ /°C.

The Young's modulus of the heat sink 60 is preferably equal to or more than 40 GPa and equal to or less than 110 GPa, more preferably equal to or more than 50 GPa and equal to or less than 100 GPa, and still more preferably equal to or more than 60 GPa and equal to or less than 90 GPa.

Note that the coefficient of linear expansion of each constituent material can be obtained by, for example, using a thermomechanical analyzer (TMA) based on JIS R 1618. Note that in the present invention, the coefficient of linear expansion indicates the coefficient of linear expansion (coefficient of linear expansion) of each constituent material at 25°C to 400 °C.

In addition, the Young's modulus of each constituent material can be measured by a static deflection method based on JIS R 1602.

<Manufacturing Method of Silicon Nitride Circuit Board>

The electronic component module 200 according to the present embodiment can be manufactured by the following method. First, a manufacturing method of the silicon nitride circuit board 100 according to the present embodiment will be described.

First, the silicon nitride substrate 10 having desired physical properties is prepared. The silicon nitride substrate 10 can be obtained by the manufacturing method below. That is, silicon nitride powder, raw material powder containing a sintering aid such as $Y_2O_3$, and MgO, an organic solvent, an organic binder, and if necessary, a plasticizer, and the like are uniformly mixed with a ball mill to obtain a raw material slurry. The obtained raw material slurry is defoamed and thickened, and then is molded into a sheet by a doctor blade method to obtain a molded body. After cutting the obtained sheet molded body, the sheet molded body is degreased at 400°C to 800°C, and is further baked in a baking furnace at 1700°C to 1900°C for 1 to 10 hours in a nitrogen atmosphere to obtain the silicon nitride substrate 10.

Next, as the brazing material containing the active metal, for example, an Ag-Cu-based alloy paste to which the active metal Ti is added is printed and formed on both surfaces of the silicon nitride substrate 10, and the copper plate having a rectangular shape substantially the same as that of the silicon nitride substrate 10 is heated and bonded to both surfaces thereof at a temperature of 600°C to 900°C. Here, as the copper plate, an oxygen-free copper plate is preferably used. In addition, as the copper plate, a rolled copper plate is more preferably used. The silicon nitride-copper composite can be obtained by bonding the copper plates to both surfaces of the silicon nitride substrate 10 through the brazing material.

Subsequently, the first copper layer 30 is subjected to etching to form the circuit pattern. A photoresist (not shown in the drawings) is laminated on an upper surface of the first copper layer 30. In this case, a liquid photoresist may be applied.

Next, in order to form the circuit pattern on the photoresist, a pattern in response to the circuit pattern is exposed. In this case, the photoresist may be exposed by bringing the film on which a negative image of the circuit pattern is formed into close contact with the photoresist by so-called batch exposure, or the photoresist may be exposed by using a so-called direct drawing type exposure device (without using the film).

Then, the exposed photoresist is subjected to etching in response to the circuit pattern.

Thereafter, the remaining photoresist is removed.

In this case, the second copper layer 20 may not be subjected to etching, or the pattern may be formed in the same manner. Further, the second copper layer 20 and the first copper layer 30 after forming the circuit pattern can be subjected to plating.

As described above, the silicon nitride circuit board 100 in a state in which the circuit pattern is formed is manufactured.

The silicon nitride circuit board 100 according to the present embodiment described above includes the silicon nitride substrate 10, the first copper layer 30 provided on one surface of the silicon nitride substrate, and the second copper layer 20 provided on the other surface of the silicon nitride substrate, in which all or a part of the silicon nitride circuit board 100 is sealed with the sealing resin portion 50, the silicon nitride circuit board 100 is used as a form in which the surface of the second copper layer 20 opposite to the surface on which the silicon nitride substrate 10 is provided is bonded to the heat sink 60 directly or through the bonding material layer 21, and in a case in which a coefficient of linear expansion of the heat sink 60 is defined as $\alpha_H$ (/°C), a Young's modulus of the heat sink 60 is defined as $E_H$ (GPa), a coefficient of linear expansion of the sealing resin portion 50 is defined as $\alpha_R$ (/°C), and a Young's modulus of the sealing resin portion 50 is defined as $E_R$ (GPa), S1 calculated by the above equation (1) is equal to or more than -0.38

(GPa) and equal to or less than -0.23 (GPa), and S2 calculated by the above equation (1) is equal to or more than -0.028 (GPa) and equal to or less than 0.019 (GPa).

Next, the electronic component 40 is mounted on the first copper layer 30 through the solder layer 31. In the present embodiment, the first copper layer 30 and the electronic component 40 are solder-bonded by using, for example, a Sn-Sb-based, Sn-Ag-based, Sn-In-based, or Sn-Ag-Cu-based solder material.

Next, the electronic component 40 and the like are sealed with a resin by using a sealing resin to form the sealing resin portion 50. A known method can be used for sealing with a resin, and for example, sealing with a resin can be performed by transfer mold. In addition, in a resin-sealing step, for example, sealing with a resin is performed in a state in which the lower surface 22 of the second copper layer of the electronic component module is pressed to the plastic material in advance, so that the uncovered region that is not covered with the sealing resin portion 50 can remain on the surface of the second copper layer 20 opposite to the surface on which the silicon nitride substrate 10 is provided, that is, the lower surface 22 of the second copper layer and the lower surface 22 of the second copper layer can protrude with respect to the lower surface 51 of the sealing resin portion.

As described above, the electronic component module 200 according to the present embodiment is manufactured.

Note that the present invention is not limited to the embodiment described above, and modifications, improvements, and the like in the scope in which the object of the present invention can be achieved are included in the present invention.

[Examples]

The present invention will be described below in detail with reference to Examples, but the present invention is not limited to the description of these Examples.

<Silicon Nitride Circuit Board>

The silicon nitride circuit board was prepared by the following method.

<Silicon Nitride Substrate>

The silicon nitride substrate having the coefficient of linear expansion $\alpha_B$, the Young's modulus $E_B$, and the thickness $T_B$ shown in Table 1 was prepared.

Specifically, 6.0 parts by mass of $Y_2O_3$ and 1.5 parts by mass of MgO were added as the sintering aids to 91.4 parts by mass of silicon nitride raw material powder having an average grain size of 0.7 um, and the organic solvent, the organic binder, the plasticizer, and the like were uniformly mixed with a ball mill to obtain the raw material slurry. The raw material slurry was defoamed and thickened, and then was molded into a sheet by the doctor blade method to obtain the molded body. After cutting the obtained sheet molded body, the sheet molded body was degreased at 500°C, and was further baked in the baking furnace at 1850°C for 5 hours in the nitrogen atmosphere to manufacture the silicon nitride substrate.

Note that the silicon nitride substrate having a size of 148 mm × 200 mm was prepared.

<Copper Plate for First Copper Layer and Second Copper Layer>

The rolled copper plate having the coefficient of linear expansion, the Young's modulus, and the thickness shown in Table 1 was prepared.

<Manufacturing Method of Silicon Nitride Circuit Board>

Silicon nitride circuit boards were manufactured by using the silicon nitride substrates and the copper plates of combinations shown in Table 1.

First, as the brazing material (including active metal), a brazing material containing 3.5 parts by mass of titanium hydride powder (manufactured by Toho Technical Service Co., Ltd.: TCH-100) with respect to a total of 100 parts by mass of 89.5 parts by mass of Ag powder (manufactured by Fukuda Metal Foil&Powder Co., Ltd.: Ag-HWQ 2.5 $\mu$m), 9.5 parts by mass of Cu powder (manufactured by Fukuda Metal Foil&Powder Co., Ltd.: Cu-HWQ 3 $\mu$m), and 1.0 part by mass of Sn powder (manufactured by Fukuda Metal Foil&Powder Co., Ltd. : Sn-HPN 3 um) was prepared.

The brazing material described above, a binder resin and the solvent were mixed to obtain a brazing material paste. The brazing material paste was applied to both surfaces of the silicon nitride substrate by a screen printing method such that a dry thickness thereof on each surface was about 10 um.

Thereafter, the copper plates were laminated on both surfaces of the silicon nitride substrate and heated in a vacuum of equal to or less than $1.0 \times 10^{-3}$ Pa at 780°C for 30 minutes to bond the silicon nitride substrate to the copper plate with the brazing material. As a result, the silicon nitride-copper composite in which the silicon nitride substrate and the copper plate were bonded with the brazing material was obtained. Further, an etching resist was printed on the obtained silicon nitride-copper composite copper layer and subjected to etching with a ferric chloride solution to form the circuit pattern, and the silicon nitride circuit board was obtained.

<Manufacturing Method of Electronic Component Module>

An IGBT element was solder-bonded as the electronic component on the circuit pattern of the obtained silicon nitride circuit board. Note that the Sn-Ag-Cu-based solder material was used. Next, the sealing resin portion was molded by the transfer mold, and the sealing resin portion was hardened.

<Evaluation Method>

(1) Coefficients of Linear Expansion ($\alpha_B$) of Copper Plate and Silicon Nitride Substrate

Based on JIS R 1618, the coefficients of linear expansion (coefficient of linear expansion) of each copper plate and each silicon nitride substrate at 25°C to 400°C were measured by using the thermomechanical analyzer (TMA).

(2) Young's Modulus ($E_B$) of Silicon Nitride Substrate

The Young's modulus was measured by the static deflection method based on JIS R1602. A shape of a test piece was 3 mm $\times$ 4 mm $\times$ 40 mm.

<Evaluation Method of Average Crystal Grain Size of Copper>

The average crystal grain sizes of the coppers in the first copper layer and the second copper layer in the silicon nitride circuit board were obtained by the following method. The average crystal grain sizes thereof were in a range of equal to or more than 50 um and equal to or less than 500 um.
First, a "cross section" for measurement was obtained by the following procedure.

(1) Each ceramic circuit board obtained in Example and Comparative Example was cut with a cross section perpendicular to a main surface and passing through the center of gravity of the board. A contour machine was used for cutting.
(2) The cut silicon nitride circuit board was embedded in a resin to create a resin embedding body.
(3) A cross section of a composite in the created resin embedding body was subjected to buff-polishing with diamond abrasive grains.

The cross section of the silicon nitride circuit board subjected to polishing above was measured by an electron backscatter diffraction method.
Specifically, first, data was acquired by performing analysis by the electron backscatter diffraction (EBSD) in an observation field of 50 times under a condition of an acceleration voltage of 15 kV substantially near the center of the first copper layer or the second copper layer subjected to polishing above . In the EBSD method, a SU6600 type field emission scanning electron microscope manufactured by Hitachi High-Technologies Corporation and an analyzer manufactured by TSL Solutions Co., Ltd. were used.
The measurement data was visualized by software: OIM Data Analysis 7.3.0 manufactured by TSL Solutions Co., Ltd. to create a crystal orientation map. The average crystal grain size of the copper crystals in the copper layer was obtained by analyzing the crystal orientation map with image processing software.
In the above, as the image processing software, Image-Pro Plus Shape Stack version 6.3 manufactured by Media Cybernetics, Inc. was used. For calculation of the average crystal grain size, an intercept method was used, ten or more straight lines of a predetermined length were drawn in parallel on one observation image, and an average value of the lengths of the straight lines of the portion in which the copper crystal particles are crossed by the straight lines was obtained as the average crystal grain size of the copper crystals (this processing was automatically performed by the software to calculate the values) .

<Thermal Cycle Test and Reliability Evaluation>

First, the electronic component module to be tested at room temperature (for example, 20°C) was moved to an environment of 150°C and held in an environment of 150°C for 15 minutes (first step).

Next, the bonding substrate was moved from an environment of 150°C to an environment of -55°C and held in an environment of -55°C for 15 minutes (second step).

Then, the first step and the second step were alternately repeated 2000 times.

Next, the presence or absence of the peeling off between the brazing material layer 13 and the first copper layer 30 was observed by ultrasound flaw detection measurement. The criteria for evaluation are shown below.

    A: No peeling off occurred.
    B: Peeling off occurred slightly.

Specifically, Example 5 in which peeling off occurred was used as a reference, and a case in which the occurrence of peeling off was observed and the degree thereof is about the same as that of Example 5, or a case in which the occurrence of peeling off was observed, but the degree thereof is less than that of Example 5 was defined as B.

C: Peeling off occurred greatly.

Specifically, Example 5 in which peeling off occurred was used as a reference, and a case in which the occurrence of peeling off was observed and the peeling off occurred more than Example 5 was defined as C.

The evaluation results are summarized in Table 1.

[Table 1]

| | Silicon nitride circuit board | | | | | | | | | Sealing resin portion | | Heat sink | | $\alpha_{BC}$ | $\alpha_{ABC}$ | S1 | S2 | Evaluation |
| | First copper layer | | | Silicon nitride substrate | | | Second copper layer | | | | | | | | | | | |
| | coefficient of linear expansion | Young's modulus | Thickness | coefficient of linear expansion | Young's modulus | Thickness | coefficient of linear expansion | Young's modulus | Thickness | coefficient of linear expansion | Young's modulus | coefficient of linear expansion | Young's modulus | | | | | |
| | $\alpha_A$ | $E_A$ | $T_A$ | $\alpha_B$ | $E_B$ | $T_B$ | $\alpha_C$ | $E_C$ | $T_C$ | $\alpha_R$ | $E_R$ | $\alpha_H$ | $E_H$ | | | | | |
| | /°C | GPa | mm | /°C | GPa | mm | /°C | GPa | mm | /°C | GPa | /°C | GPa | /°C | /°C | GPa | GPa | |
| Example 1 | $17 \times 10^{-6}$ | 120 | 0.3 | $2.5 \times 10^{-6}$ | 300 | 0.32 | $17 \times 10^{-6}$ | 120 | 0.3 | $10 \times 10^{-6}$ | 20 | $24 \times 10^{-6}$ | 70 | $6.45 \times 10^{-6}$ | $8.71 \times 10^{-6}$ | -0.325 | -0.007 | A |
| Example 2 | $17 \times 10^{-6}$ | 120 | 0.3 | $2.5 \times 10^{-6}$ | 300 | 0.32 | $17 \times 10^{-6}$ | 120 | 0.3 | $10 \times 10^{-6}$ | 20 | $24 \times 10^{-6}$ | 70 | $6.45 \times 10^{-6}$ | $8.71 \times 10^{-6}$ | -0.325 | -0.007 | A |
| Example 3 | $17 \times 10^{-6}$ | 120 | 0.3 | $2.5 \times 10^{-6}$ | 300 | 0.32 | $17 \times 10^{-6}$ | 120 | 0.3 | $10 \times 10^{-6}$ | 20 | $24 \times 10^{-6}$ | 70 | $6.45 \times 10^{-6}$ | $8.71 \times 10^{-6}$ | -0.325 | -0.007 | A |
| Example 4 | $17 \times 10^{-6}$ | 120 | 0.3 | $2.5 \times 10^{-6}$ | 300 | 0.32 | $17 \times 10^{-6}$ | 120 | 0.3 | $10 \times 10^{-6}$ | 20 | $24 \times 10^{-6}$ | 70 | $6.45 \times 10^{-6}$ | $8.71 \times 10^{-6}$ | -0.325 | -0.007 | A |
| Example 5 | $17 \times 10^{-6}$ | 120 | 0.3 | $2.5 \times 10^{-6}$ | 300 | 0.32 | $17 \times 10^{-6}$ | 120 | 1 | $10 \times 10^{-6}$ | 20 | $24 \times 10^{-6}$ | 70 | $10.6 \times 10^{-6}$ | $11.5 \times 10^{-6}$ | -0.249 | 0.008 | B |
| Example 6 | $17 \times 10^{-6}$ | 120 | 1 | $2.5 \times 10^{-6}$ | 300 | 0.32 | $17 \times 10^{-6}$ | 120 | 0.3 | $10 \times 10^{-6}$ | 20 | $24 \times 10^{-6}$ | 70 | $6.45 \times 10^{-6}$ | $11.5 \times 10^{-6}$ | -0.325 | 0.008 | B |
| Example 7 | $17 \times 10^{-6}$ | 120 | 0.3 | $2.5 \times 10^{-6}$ | 300 | 0.32 | $17 \times 10^{-6}$ | 120 | 0.3 | $10 \times 10^{-6}$ | 20 | $24 \times 10^{-6}$ | 70 | $6.45 \times 10^{-6}$ | $8.71 \times 10^{-6}$ | -0.363 | -0.007 | B |
| Example 8 | $17 \times 10^{-6}$ | 120 | 0.3 | $2.5 \times 10^{-6}$ | 300 | 0.32 | $17 \times 10^{-6}$ | 120 | 0.3 | $7 \times 10^{-6}$ | 20 | $24 \times 10^{-6}$ | 70 | $6.45 \times 10^{-6}$ | $8.71 \times 10^{-6}$ | -0.325 | 0.009 | B |

| | Silicon nitride circuit board | | | | | | | | | Sealing resin portion | | Heat sink | | | | | | |
| | First copper layer | | | Silicon nitride substrate | | | Second copper layer | | | | | | | | | | | |
| | coefficient of linear expansion | Young's modulus | Thickness | coefficient of linear expansion | Young's modulus | Thickness | coefficient of linear expansion | Young's modulus | Thickness | coefficient of linear expansion | Young's modulus | coefficient of linear expansion | Young's modulus | $\alpha_{BC}$ | $\alpha_{ABC}$ | S1 | S2 | Evaluation |
| | $\alpha_A$ | $E_A$ | $T_A$ | $\alpha_B$ | $E_B$ | $T_B$ | $\alpha_C$ | $E_C$ | $T_C$ | $\alpha_R$ | $E_R$ | $\alpha_H$ | $E_H$ | | | | | |
| | /°C | GPa | mm | /°C | GPa | mm | /°C | GPa | mm | /°C | GPa | /°C | GPa | /°C | /°C | GPa | GPa | |
| Comparative Example 1 | $17 \times 10^{-6}$ | 120 | 0.3 | $2.5 \times 10^{-6}$ | 300 | 0.32 | $17 \times 10^{-6}$ | 120 | 0.3 | $10 \times 10^{-6}$ | 20 | $24 \times 10^{-6}$ | 120 | $6.45 \times 10^{-6}$ | $8.71 \times 10^{-6}$ | -0.558 | -0.007 | C |
| Comparative Example 2 | $17 \times 10^{-6}$ | 120 | 0.3 | $2.5 \times 10^{-6}$ | 300 | 0.05 | $17 \times 10^{-6}$ | 120 | 0.3 | $10 \times 10^{-6}$ | 15 | $24 \times 10^{-6}$ | 70 | $12.7 \times 10^{-6}$ | $14.5 \times 10^{-6}$ | -0.209 | 0.018 | C |
| Comparative Example 3 | $17 \times 10^{-6}$ | 120 | 0.3 | $2.5 \times 10^{-6}$ | 300 | 0.32 | $17 \times 10^{-6}$ | 120 | 0.3 | $10 \times 10^{-6}$ | 100 | $24 \times 10^{-6}$ | 70 | $6.45 \times 10^{-6}$ | $8.71 \times 10^{-6}$ | -0.325 | -0.034 | C |
| Comparative Example 4 | $17 \times 10^{-6}$ | 120 | 0.3 | $2.5 \times 10^{-6}$ | 300 | 0.05 | $17 \times 10^{-6}$ | 120 | 0.3 | $10 \times 10^{-6}$ | 20 | $24 \times 10^{-6}$ | 70 | $12.7 \times 10^{-6}$ | $14.5 \times 10^{-6}$ | -0.209 | 0.024 | C |

# EP 3 961 694 B1

As is clear from Examples 1 to 8 and Comparative Examples 1 to 4, by setting S1 and S2 in a predetermined range, the electronic component module having high reliability can be stably obtained. From the above, it is understood that it is important to control S1 and S2 in the range defined in the present invention in order to stably obtain the electronic component module having high reliability.

REFERENCE SIGNS LIST

| | |
|---|---|
| 10: | silicon nitride substrate |
| 12: | brazing material layer |
| 13: | brazing material layer |
| 20: | second copper layer |
| 21: | bonding material layer |
| 22: | lower surface of second copper layer |
| 30: | first copper layer |
| 31: | solder layer |
| 40: | electronic component |
| 50: | sealing resin portion |
| 51: | lower surface of sealing resin portion |
| 60: | heat sink |
| 70: | external connection terminal |
| 71: | wire bonding |
| 100: | silicon nitride circuit board |
| 200: | electronic component module |

**Claims**

1. An electronic component module comprising:

   a silicon nitride circuit board;
   an electronic component mounted over the silicon nitride circuit board; and
   a sealing resin portion that seals all or a part of the silicon nitride circuit board and the electronic component,
   wherein the silicon nitride circuit board includes a silicon nitride substrate, a first copper layer provided over one surface of the silicon nitride substrate, and a second copper layer provided over the other surface of the silicon nitride substrate,
   a surface of the second copper layer opposite to a surface over which the silicon nitride substrate is provided is bonded to a heat sink directly or through a bonding material layer,
   **characterised in that**
   in a case in which a coefficient of linear expansion of the heat sink is defined as $\alpha_H$ (/°C), a Young's modulus of the heat sink is defined as $E_H$ (GPa), a coefficient of linear expansion of the sealing resin portion is defined as $\alpha_R$ (/°C), and a Young's modulus of the sealing resin portion is defined as $E_R$ (GPa), S1 calculated by the following equation (1) is equal to or more than -0.38 (GPa) and equal to or less than -0.23 (GPa), and S2 calculated by the following equation (2) is equal to or more than -0.028 (GPa) and equal to or less than 0.019 (GPa),

$$\text{Equation (1): } S1 = (\alpha_{BC} - \alpha_H) \times E_H \times (290 - 25),$$

   wherein $\alpha_{BC}$ is an approximate value of a coefficient of linear expansion of a composite laminate of the silicon nitride substrate and the second copper layer, and in a case in which a coefficient of linear expansion of the silicon nitride substrate is defined as $\alpha_B$ (/°C), a Young's modulus of the silicon nitride substrate is defined as $E_B$ (GPa), a thickness of the silicon nitride substrate is defined as $T_B$ (mm), a coefficient of linear expansion of the second copper layer is defined as $\alpha_C$ (/°C), a Young's modulus of the second copper layer is defined as $E_C$ (GPa), and a thickness of the second copper layer is defined as $T_C$ (mm), $\alpha_{BC}$ is calculated by the following equation (3),

Equation (3): $\alpha_{BC}$ = (($\alpha_B$ × $E_B$ × $T_B$) + ($\alpha_C$ × $E_C$ × $T_C$))/(($EB$ × $T_B$) + ($E_C$ × $T_C$)),

and

Equation (2): S2 = ($\alpha_{ABC}$ − $\alpha_R$) × $E_R$ × (290 − 25),

wherein $\alpha_{ABC}$ is an approximate value of a coefficient of linear expansion of a composite laminate of the first copper layer, the silicon nitride substrate, and the second copper layer, and in a case in which a coefficient of linear expansion of the first copper layer is defined as $\alpha_A$ (/°C), a Young's modulus of the first copper layer is defined as $E_A$ (GPa), a thickness of the first copper layer is defined as $T_A$ (mm), the coefficient of linear expansion of the silicon nitride substrate is defined as $\alpha_B$ (/°C), the Young's modulus of the silicon nitride substrate is defined as $E_B$ (GPa), the thickness of the silicon nitride substrate is defined as $T_B$ (mm), the coefficient of linear expansion of the second copper layer is defined as $\alpha_C$ (/°C) , the Young's modulus of the second copper layer is defined as $E_C$ (GPa), and the thickness of the second copper layer is defined as $T_C$ (mm), $\alpha_{ABC}$ is calculated by the following equation (4),

Equation (4): $\alpha_{ABC}$ = (($\alpha_A$ × $E_A$ × $T_A$) + (($\alpha_B$ × $E_B$ × $T_B$) + ($\alpha_C$ × $E_C$ × $T_C$))/(($E_A$ × $T_A$) + ($E_B$ × $T_B$) + ($E_C$ × $T_C$)).

2. The electronic component module according to claim 1,
   wherein the surface of the second copper layer opposite to the surface over which the silicon nitride substrate is provided has an uncovered region that is not covered with the sealing resin portion.

3. The electronic component module according to claim 1 or 2,
   wherein the coefficient of linear expansion of the sealing resin portion is equal to or more than $5 \times 10^{-6}$ /°C and equal to or less than $30 \times 10^{-6}$ /°C.

4. The electronic component module according to any one of claims 1 to 3,
   wherein the Young's modulus of the sealing resin portion is equal to or more than 50 GPa and equal to or less than 80 GPa.

5. The electronic component module according to any one of claims 1 to 4,
   wherein the coefficient of linear expansion of the heat sink is equal to or more than $20 \times 10^{-6}$ /°C and equal to or less than $30 \times 10^{-6}$ /°C.

6. The electronic component module according to any one of claims 1 to 5,
   wherein the Young's modulus of the heat sink is equal to or more

7. The electronic component module according to any one of claims 1 to 6,
   wherein the first copper layer is a copper layer formed in a circuit pattern.

8. The electronic component module according to any one of claims 1 to 7,
   wherein the thickness of the first copper layer is equal to or more than 0.15 mm and equal to or less than 0.80 mm.

9. The electronic component module according to any one of claims 1 to 8,
   wherein an average crystal grain size of copper crystals in the first copper layer is equal to or more than 50 um and equal to or less than 500 $\mu$m.

10. The electronic component module according to any one of claims 1 to 9,
    wherein the second copper layer is a copper layer for bonding to a heat sink.

**11.** The electronic component module according to any one of claims 1 to 10,
wherein the thickness of the second copper layer is equal to or more than 0.15 mm and equal to or less than 0.80 mm.

**12.** The electronic component module according to any one of claims 1 to 11,
wherein an average crystal grain size of copper crystals in the second copper layer is equal to or more than 50 um and equal to or less than 500 $\mu$m.

**13.** The electronic component module according to any one of claims 1 to 12,
wherein the Young's modulus $E_B$ of the silicon nitride substrate is equal to or more than 250 GPa and equal to or less than 320 GPa.

**14.** The electronic component module according to any one of claims 1 to 13,
wherein the coefficient of linear expansion $\alpha_B$ of the silicon nitride substrate is equal to or more than $1.5 \times 10^{-6}$ /°C and equal to or less than $4.0 \times 10^{-6}$ /°C.

**15.** The electronic component module according to any one of claims 1 to 14,
wherein the surface of the second copper layer opposite to the surface over which the silicon nitride substrate is provided protrudes further than the sealing resin portion in a direction away from the silicon nitride substrate.

**Patentansprüche**

**1.** Elektronisches Bauteilmodul, bestehend aus:

eine Siliziumnitrid-Leiterplatte;
ein elektronisches Bauteil, das über der Siliziumnitrid-Leiterplatte angebracht ist; und
einen Dichtungsharzteil, der die Siliziumnitrid-Leiterplatte und das elektronische Bauteil ganz oder teilweise versiegelt,
wobei die Siliziumnitrid-Leiterplatte ein Siliziumnitrid-Substrat, eine erste Kupferschicht, die über einer Oberfläche des Siliziumnitrid-Substrats vorgesehen ist, und eine zweite Kupferschicht, die über der anderen Oberfläche des Siliziumnitrid-Substrats vorgesehen ist, umfasst,
eine Oberfläche der zweiten Kupferschicht, die einer Oberfläche gegenüberliegt, über der das Siliziumnitridsubstrat vorgesehen ist, direkt oder über eine Bindematerialschicht mit einem Kühlkörper verbunden ist,
**dadurch gekennzeichnet, dass**,
in einem Fall, in dem ein linearer Ausdehnungskoeffizient der Wärmesenke definiert ist als $\alpha_H$ (/°C), ein Elastizitätsmodul der Wärmesenke definiert ist als $E_H$ (GPa), ein linearer Ausdehnungskoeffizient des Dichtungsharzteils definiert ist als $\alpha_R$ (/°C) und ein Elastizitätsmodul des Dichtungsharzteils definiert ist als $E_R$ (GPa), S1, berechnet durch die folgende Gleichung (1), gleich oder mehr als -0.38 (GPa) und gleich oder kleiner als -0,23 (GPa) ist, und S2, berechnet nach der folgenden Gleichung (2), gleich oder größer als -0,028 (GPa) und gleich oder kleiner als 0,019 (GPa) ist,

$$\text{Gleichung (1): } S1 = (\alpha_{BC} - \alpha_H) \times E_H \times (290 - 25),$$

wobei $\alpha_{BC}$ ein Näherungswert eines linearen Ausdehnungskoeffizienten eines Verbundlaminats aus dem Siliziumnitridsubstrat und der zweiten Kupferschicht ist, und in einem Fall, in dem ein linearer Ausdehnungskoeffizient des Siliziumnitridsubstrats als $\alpha_B$ (/°C) definiert ist, ein Elastizitätsmodul des Siliziumnitridsubstrats als $E_B$ (GPa) definiert ist, eine Dicke des Siliziumnitrid-Substrats als $T_B$ (mm) definiert ist, ein linearer Ausdehnungskoeffizient der zweiten Kupferschicht als $\alpha_C$ (/°C) definiert ist, ein Elastizitätsmodul der zweiten Kupferschicht als $E_C$ (GPa) definiert ist, und eine Dicke der zweiten Kupferschicht als $T_C$ (mm) definiert ist, $\alpha_{BC}$ durch die folgende Gleichung (3) berechnet wird,

$$\text{Gleichung (3): } \alpha_{BC} = ((\alpha_B \times E_B \times T_B) + (\alpha_C \times E_C \times T_C))/((EB \times T_B) + (E_C \times T_C)),$$

und

$$\text{Gleichung (2): } S2 = (\alpha_{ABC} - \alpha_R) \times E_R \times (290 - 25),$$

wobei $\alpha_{ABC}$ ein Näherungswert eines linearen Ausdehnungskoeffizienten eines Verbundlaminats aus der ersten Kupferschicht, dem Siliziumnitrid-Substrat und der zweiten Kupferschicht ist, und in einem Fall, in dem ein linearer Ausdehnungskoeffizient der ersten Kupferschicht als $\alpha_A$ (/°C) definiert ist, ein Elastizitätsmodul der ersten Kupferschicht als $E_A$ (GPa) definiert ist, eine Dicke der ersten Kupferschicht als $T_A$ (mm) definiert ist, der lineare Ausdehnungskoeffizient des Siliziumnitrid-Substrats als $\alpha_B$ (/°C) definiert ist, der Elastizitätsmodul des Siliziumnitrid-Substrats ist definiert als $E_B$ (GPa), die Dicke des Siliziumnitrid-Substrats ist definiert als $T_B$ (mm), der lineare Ausdehnungskoeffizient der zweiten Kupferschicht ist definiert als $\alpha_C$ (/°C), der Elastizitätsmodul der zweiten Kupferschicht ist definiert als $E_C$ (GPa), und die Dicke der zweiten Kupferschicht ist definiert als $T_C$ (mm), $\alpha_{ABC}$ durch die folgende Gleichung (4) berechnet wird,

$$\text{Gleichung (4): } \alpha_{ABC} = ((\alpha_A \times E_A \times T_A) + ((\alpha_B \times E_B \times T_B) + (\alpha_C \times E_C$$

$$\times T_C))/((E_A \times T_A) + (E_B \times T_B) + (E_C \times T_C)).$$

2. Elektronisches Bauteilmodul nach Anspruch 1,
   wobei die Oberfläche der zweiten Kupferschicht gegenüber der Oberfläche, auf der das Siliziumnitridsubstrat vorgesehen ist, einen unbedeckten Bereich aufweist, der nicht mit dem Versiegelungsharzteil bedeckt ist.

3. Elektronisches Bauteilmodul nach Anspruch 1 oder 2,
   wobei der lineare Ausdehnungskoeffizient des Dichtungsharzteils gleich oder mehr als $5 \times 10^{-6}$ /°C und gleich oder weniger als $30 \times 10^{-6}$ /°C beträgt.

4. Elektronisches Bauteilmodul nach einem der Ansprüche 1 bis 3,
   wobei der Elastizitätsmodul des Dichtungsharzteils gleich oder mehr als 50 GPa und gleich oder weniger als 80 GPa beträgt.

5. Elektronisches Bauteilmodul nach einem der Ansprüche 1 bis 4,
   wobei der lineare Ausdehnungskoeffizient des Kühlkörpers gleich oder mehr als $20 \times 10^{-6}$ /°C und gleich oder weniger als $30 \times 10^{-6}$ /°C beträgt.

6. Elektronisches Bauteilmodul nach einem der Ansprüche 1 bis 5,
   wobei der Elastizitätsmodul des Kühlkörpers gleich oder mehr als 40 GPa und gleich oder weniger als 110 GPa beträgt.

7. Elektronisches Bauteilmodul nach einem der Ansprüche 1 bis 6,
   wobei die erste Kupferschicht eine in einem Schaltungsmuster ausgebildete Kupferschicht ist.

8. Elektronisches Bauteilmodul nach einem der Ansprüche 1 bis 7,
   wobei die Dicke der ersten Kupferschicht gleich oder mehr als 0,15 mm und gleich oder weniger als 0,80 mm beträgt.

9. Elektronisches Bauteilmodul nach einem der Ansprüche 1 bis 8,
   wobei die durchschnittliche Kristallkorngröße der Kupferkristalle in der ersten Kupferschicht gleich oder größer als 50 $\mu$m und gleich oder kleiner als 500 um ist.

10. Elektronisches Bauteilmodul nach einem der Ansprüche 1 bis 9,
    wobei die zweite Kupferschicht eine Kupferschicht zum Verbinden mit einem Kühlkörper ist.

11. Elektronisches Bauteilmodul nach einem der Ansprüche 1 bis 10,
    wobei die Dicke der zweiten Kupferschicht gleich oder mehr als 0,15 mm und gleich oder weniger als 0,80 mm beträgt.

12. Elektronisches Bauteilmodul nach einem der Ansprüche 1 bis 11,
    wobei die durchschnittliche Kristallkorngröße der Kupferkristalle in der zweiten Kupferschicht gleich oder größer als 50 um und gleich oder kleiner als 500 um ist.

**13.** Elektronisches Bauteilmodul nach einem der Ansprüche 1 bis 12, wobei der Elastizitätsmodul $E_B$ des Siliziumnitrid-Substrats gleich oder mehr als 250 GPa und gleich oder weniger als 320 GPa beträgt.

**14.** Elektronisches Bauteilmodul nach einem der Ansprüche 1 bis 13, wobei der lineare Ausdehnungskoeffizient $\alpha_B$ des Siliciumnitrid-Substrats gleich oder mehr als $1,5 \times 10^{-6}$ /°C und gleich oder weniger als $4,0 \times 10^{-6}$ /°C beträgt.

**15.** Elektronisches Bauteilmodul nach einem der Ansprüche 1 bis 14, wobei die Oberfläche der zweiten Kupferschicht, die der Oberfläche gegenüberliegt, über der das Siliziumnitridsubstrat vorgesehen ist, in einer Richtung weg von dem Siliziumnitridsubstrat weiter vorsteht als der Dichtungsharzteil.

**Revendications**

**1.** Module de composants électroniques comprenant :

un circuit imprimé en nitrure de silicium ;
un composant électronique monté sur la carte de circuit imprimé en nitrure de silicium ; et
une partie de résine de scellement qui scelle tout ou partie de la carte de circuit imprimé en nitrure de silicium et du composant électronique,
la carte de circuit imprimé en nitrure de silicium comprend un substrat en nitrure de silicium, une première couche de cuivre appliquée sur une surface du substrat en nitrure de silicium et une deuxième couche de cuivre appliquée sur l'autre surface du substrat en nitrure de silicium,
une surface de la deuxième couche de cuivre opposée à une surface sur laquelle le substrat de nitrure de silicium est fourni est liée à un dissipateur thermique directement ou par l'intermédiaire d'une couche de matériau de liaison,
**caractérisé par le fait que**
dans un cas où un coefficient de dilatation linéaire du dissipateur thermique est défini comme $\alpha_H$ (/°C), un module d'Young du dissipateur thermique est défini comme $E_H$ (GPa), un coefficient de dilatation linéaire de la partie en résine de scellement est défini comme $\alpha_R$ (/°C), et un module d'Young de la partie en résine de scellement est défini comme $E_R$ (GPa), S1 calculé par l'équation suivante (1) est égal ou supérieur à -0,38 (GPa) et égal ou inférieur à -0,23 (GPa), et S2 calculé par l'équation suivante (2) est égal ou supérieur à -0,028 (GPa) et égal ou inférieur à -0,19 (GPa),

$$\text{Équation (1) : } S1 = (\alpha_{BC} - \alpha_H) \times E_H \times (290 - 25),$$

où $\alpha_{BC}$ est une valeur approximative d'un coefficient de dilatation linéaire d'un stratifié composite du substrat de nitrure de silicium et de la deuxième couche de cuivre, et dans un cas où un coefficient de dilatation linéaire du substrat de nitrure de silicium est défini comme $\alpha_B$ (/°C), un module d'Young du substrat de nitrure de silicium est défini comme $E_B$ (GPa), une épaisseur du substrat de nitrure de silicium est définie comme $T_B$ (mm), un coefficient de dilatation linéaire de la deuxième couche de cuivre est défini comme $\alpha_C$ (/°C), un module de Young de la deuxième couche de cuivre est défini comme $E_C$ (GPa), et une épaisseur de la deuxième couche de cuivre est définie comme $T_C$ (mm), $\alpha_{BC}$ est calculé par l'équation suivante (3),

$$\text{Équation (3) : } \alpha_{BC} = ((\alpha_B \times E_B \times T_B) + (\alpha_C \times E_C \times T_C))/((EB \times T_B)$$

$$+ (E_C \times T_C)),$$

et

$$\text{Équation (2) : } S2 = (\alpha_{ABC} - \alpha_R) \times E_R \times (290 - 25),$$

dans lequel $\alpha_{ABC}$ est une valeur approximative d'un coefficient de dilatation linéaire d'un stratifié composite de la première couche de cuivre, du substrat de nitrure de silicium et de la deuxième couche de cuivre, et dans un cas où un coefficient de dilatation linéaire de la première couche de cuivre est défini comme $\alpha_A$ (/°C), le module d'Young de la première couche de cuivre est défini comme $E_A$ (GPa), l'épaisseur de la première couche de cuivre est définie comme $T_A$ (mm), le coefficient de dilatation linéaire du substrat de nitrure de silicium est défini comme $\alpha_B$ (/°C), le module d'Young du substrat de nitrure de silicium est défini comme $E_B$ (GPa), l'épaisseur du substrat de nitrure de silicium est définie comme $T_B$ (mm), le coefficient de dilatation linéaire de la deuxième couche de cuivre est défini comme $\alpha_C$ (/°C), le module d'Young de la deuxième couche de cuivre est défini comme $E_C$ (GPa), et l'épaisseur de la deuxième couche de cuivre est définie comme $T_C$ (mm), $\alpha_{ABC}$ est calculé par l'équation suivante (4),

$$\text{Équation (4)} : \alpha_{ABC} = ((\alpha_A \times E_A \times T_A) + ((\alpha_B \times E_B \times T_B) + (\alpha_C \times E_C \times T_C)) / ((E_A \times T_A) + (E_B \times T_B) + (E_C \times T_C)).$$

**2.** Module de composants électroniques selon la revendication 1,
dans lequel la surface de la deuxième couche de cuivre opposée à la surface sur laquelle le substrat de nitrure de silicium est fourni présente une région non couverte qui n'est pas recouverte par la partie de résine de scellement.

**3.** Module de composants électroniques selon la revendication 1 ou 2,
dans lequel le coefficient de dilatation linéaire de la partie en résine de scellement est égal ou supérieur à $5 \times 10^{-6}$ /°C et égal ou inférieur à $30 \times 10^{-6}$ /°C.

**4.** Module de composants électroniques selon l'une des revendications 1 à 3,
dans lequel le module de Young de la portion de résine de scellement est supérieur ou égal à 50 GPa et inférieur ou égal à 80 GPa.

**5.** Module de composants électroniques selon l'une des revendications 1 à 4,
dans lequel le coefficient de dilatation linéaire du dissipateur thermique est égal ou supérieur à $20 \times 10^{-6}$ /°C et égal ou inférieur à $30 \times 10^{-6}$ /°C.

**6.** Module de composants électroniques selon l'une des revendications 1 à 5,
dans lequel le module d'Young du dissipateur thermique est supérieur ou égal à 40 GPa et inférieur ou égal à 110 GPa.

**7.** Module de composants électroniques selon l'une des revendications 1 à 6,
dans lequel la première couche de cuivre est une couche de cuivre formée dans un schéma de circuit.

**8.** Module de composants électroniques selon l'une des revendications 1 à 7,
dans lequel l'épaisseur de la première couche de cuivre est égale ou supérieure à 0,15 mm et égale ou inférieure à 0,80 mm.

**9.** Module de composants électroniques selon l'une des revendications 1 à 8,
dans lequel une taille moyenne des cristaux de cuivre dans la première couche de cuivre est égale ou supérieure à 50 um et égale ou inférieure à 500 $\mu$m.

**10.** Module de composants électroniques selon l'une des revendications 1 à 9,
dans lequel la deuxième couche de cuivre est une couche de cuivre destinée à être collée à un dissipateur thermique.

**11.** Module de composants électroniques selon l'une des revendications 1 à 10,
dans lequel l'épaisseur de la deuxième couche de cuivre est égale ou supérieure à 0,15 mm et égale ou inférieure à 0,80 mm.

**12.** Module de composants électroniques selon l'une des revendications 1 à 11,
dans lequel une taille moyenne des grains de cristaux de cuivre dans la deuxième couche de cuivre est égale ou supérieure à 50 um et égale ou inférieure à 500 $\mu$m.

**13.** Module de composants électroniques selon l'une des revendications 1 à 12,
dans lequel le module d'Young $E_B$ du substrat en nitrure de silicium est supérieur ou égal à 250 GPa et inférieur ou égal à 320 GPa.

**14.** Module de composants électroniques selon l'une des revendications 1 à 13,
dans lequel le coefficient de dilatation linéaire $\alpha_B$ du substrat en nitrure de silicium est égal ou supérieur à $1,5 \times 10^{-6}$ /°C et égal ou inférieur à $4,0 \times 10^{-6}$ /°C.

**15.** Module de composants électroniques selon l'une des revendications 1 à 14,
dans lequel la surface de la deuxième couche de cuivre opposée à la surface sur laquelle le substrat de nitrure de silicium est fourni dépasse davantage que la partie de résine d'étanchéité dans une direction opposée au substrat de nitrure de silicium.

Fig.1

(a)

(b)

(c)

Fig.2

Fig.3

Fig.4

**EP 3 961 694 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2018046192 A